# EUROPEAN PATENT APPLICATION

(11) **EP 4 804 763 A2**
(43) Date of publication of application: **09.09.2026**
(21) Application number: 26160097.7
(22) Date of filing: 23.02.2026
(51) Int. Cl.: H10D 84/90, H10D 89/10, H10W 20/41, H10D 84/01, H10D 88/00

(54) **ENGINEERING CHANGE ORDER CELL USING DUAL POWER RAILS**

(30) Priority: 05.03.2025 US 202563767388 P; 07.10.2025 US 202519351702
(71) Applicant: Samsung Electronics Co., Ltd., Suwon-si, Gyeonggi-do 16677 (KR)
(72) Inventor: LIM, Jinyoung, 16677 Suwon-si, Gyeonggi-do (KR); CHO, Edward Namkyu, 16677 Suwon-si, Gyeonggi-do (KR); PARK, Young Gook, San Jose, CA 95134 (US); SHIN, Hyojong, 16677 Suwon-si, Gyeonggi-do (KR); SEO, Kang-Ill, 16677 Suwon-si, Gyeonggi-do (KR)
(74) Representative: Kuhnen & Wacker Patent- und Rechtsanwaltsbüro PartG mbB

(57) **Abstract**

An integrated circuit device includes an engineering change order, ECO, transistor cell structure (102) including a first region (I) and a second region (II) adjacent the first region (I), and a backside power rail (105b) extending in a first direction (X) under the ECO transistor cell structure (102). The first region (I) of the ECO transistor cell structure (102) is free of overlap with the backside power rail (105b) in a second direction (Y) that is perpendicular to the first direction (X). The second region (II) of the ECO transistor cell structure (102) overlaps the backside power rail (105b) in the second direction (Y), and includes one or more conductive elements (108f) that electrically connect the backside power rail (105b) to a frontside power rail (115f). Related devices and revision methods are also discussed.

## Description

### TECHNICAL FIELD

The present disclosure relates to integrated circuit devices and methods of forming the same.

### BACKGROUND

As demand for higher performance for integrated circuit devices increase, engineering change order (ECO) processes have been developed. ECO processes allow for changing an existing layout of a cell architecture of the integrated circuit device after an initial design or chip masking operation of the cell architecture is finished. For example, when it is determined that connection structures in one or more cells of a cell architecture can be changed to reduce performance degradation or improve performance of the integrated circuit device, an ECO may be issued to require one or more metal lines, vias, or contact structures to be added, removed, or repositioned (e.g., rerouted) in the cell architecture. These metal line, vias and contact structures may (electrically) connect one or more device elements such as transistors in the cells to another circuit element in or out of the cell architecture.

In order to implement ECO processes, integrated circuit devices may be manufactured to include ECO cells, which may be distributed among the functional cells of an integrated circuit device. An ECO cell may refer to a type of cell used in integrated circuit design to implement changes or fixes to a chip design after an initial design has been completed. The ECO cells are designed to be configurable, allowing them to be modified into various functional cells by changing only some layers (e.g., masks). This means that only necessary layers are altered, reducing the need for a complete redesign and refabrication. Changes (e.g., for bug fixes, feature enhancements, or other modifications) may thus be implemented without restarting the entire design process.

### SUMMARY

Some embodiments of the present disclosure may be directed to integrated circuit devices including cell architectures in which ECO cells are supplied with power from Front-Side Power Delivery Networks (FSPDNs), rather than from Back-Side Power Delivery Networks (BSPDNs). More particularly, the ECO cells include ECO regions that include an overlying FSPDN, and one or more power tab regions that provide electrical connection from the FSPDN to an underlying BSPDN. The ECO regions may be free of overlap with underlying BSPDNs, such that only frontside layers of the ECO regions need be revised to provide functional transistor cells, and backside layers of the ECO cells need not be modified to implement revisions.

According to some embodiments, an integrated circuit device includes an engineering change order (ECO) transistor cell structure comprising a first region and a second region adjacent the first region, and a backside power rail extending in a first direction under the ECO transistor cell structure, wherein the first region of the ECO transistor cell structure is free of overlap with the backside power rail in a second direction that is perpendicular to the first direction.

In some embodiments, the integrated circuit device further comprises a frontside power rail extending in the first direction over the ECO transistor cell structure, where the frontside power rail overlaps the first region and the second region of the ECO transistor cell in the second direction.

In some embodiments, the second region of the ECO transistor cell structure overlaps the backside power rail in the second direction, and comprises one or more conductive elements that electrically connect the backside power rail to the frontside power rail.

In some embodiments, the second region of the ECO transistor cell structure includes a source/drain region. The one or more conductive elements comprise a backside contact on the source/drain region, where the backside contact electrically connects the source/drain region to the backside power rail. A frontside contact is provided on the source/drain region opposite the backside contact, where the frontside contact electrically connects the source/drain region to the frontside power rail.

In some embodiments, the frontside power rail does not overlap the backside power rail in the second direction and is spaced apart therefrom in a third direction that intersects the first direction, and where the one or more conductive elements further comprise a conductive via on the frontside power rail, and a conductive line extending in the third direction and electrically connecting the conductive via to the frontside contact.

In some embodiments, the first region of the ECO transistor cell structure comprises a source/drain region and a frontside contact on the source/drain region adjacent the frontside power rail, where the source/drain region is free of a backside contact thereon opposite the frontside contact.

In some embodiments, the frontside contact is electrically isolated from the frontside power rail.

In some embodiments, the first region of the ECO transistor cell structure further comprises at least one revised conductive structure that electrically connects the frontside contact to the front side power rail.

In some embodiments, the frontside power rail does not overlap the frontside contact in the second direction and is laterally spaced apart therefrom in a third direction that intersects the first direction, and where the at least one revised conductive structure comprises a conductive via on the frontside power rail, and a conductive line extending in the third direction and electrically connecting the conductive via to the frontside contact, where the frontside power rail, the conductive via, the conductive line, and the frontside contact are in different layers of the ECO transistor cell structure.

In some embodiments, the integrated circuit device further comprises a second transistor cell structure adjacent the ECO transistor cell structure in the first direction, where the second transistor cell structure overlaps the backside power rail in the second direction and is free of overlap with the frontside power rail in the second direction.

According to some embodiments, an integrated circuit device comprises a backside power delivery network (BSPDN), a frontside power delivery network (FSPDN), and an engineering change order (ECO) transistor cell structure that is between the BSPDN and the FSPDN, where the ECO transistor cell structure comprises a first region that is electrically connected to the FSPDN, and a second region that is adjacent the first region and electrically connects the FSPDN to the BSPDN.

In some embodiments, a transistor of the first region of the ECO transistor cell is free of a backside contact that is electrically connected to the BSPDN.

In some embodiments, the BSPDN does not extend under the first region of the ECO transistor cell structure.

In some embodiments, the second region of the ECO transistor cell structure comprises a transistor having a frontside contact that is electrically connected to the FSPDN, and a backside contact that is electrically connected to the BSPDN.

In some embodiments, the first region of the ECO transistor cell comprises a transistor having a frontside contact adjacent the FSPDN, and at least one revised conductive structure that electrically connects the frontside contact to the FSPDN.

In some embodiments, the at least one revised conductive structure comprises a conductive via and a conductive metal line in respective layers of the ECO transistor cell structure that are between the FSPDN and the frontside contact.

In some embodiments, the first region of the ECO transistor cell structure is free of conductive structures in respective layers of the ECO transistor cell structure below the transistor.

According to some embodiments, an integrated circuit device comprises a backside power delivery network (BSPDN), a frontside power delivery network (FSPDN), and first and second transistor cell structures that are adjacent one another in a first direction and are between the BSPDN and the FSPDN in a second direction that is perpendicular to the first direction. The first transistor cell structure includes an engineering change order (ECO) cell having a first region and a second region that is adjacent the first region, where the first region of the ECO cell is free of overlap with the BSPDN in the second direction.

In some embodiments, the first region of the ECO cell comprises a first transistor structure that is electrically connected to a frontside power rail of the FSPDN extending in the first direction, and the second region of the ECO cell comprises one or more conductive elements that electrically connect a backside power rail of the BSPDN to the frontside power rail.

In some embodiments, the second transistor cell structure comprises a second transistor structure that is electrically connected to a backside power rail of the BSPDN by a backside contact and is free of a frontside contact that is electrically connected to the FSPDN.

In some embodiments, the second transistor cell structure is configured to be supplied with power from the backside power rail, and the first region of the ECO transistor cell structure is configured to be supplied with power from the front side power rail.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the present disclosure, and be protected by the accompanying claims.

### BRIEF DESCRIPTION OF THE DRAWINGS

FIG. 1A is a schematic plan view diagram illustrating layout of a cell architecture including functional transistor cell structures in integrated circuit devices according to some embodiments of the present disclosure.
FIG. 1B is a schematic plan view diagram illustrating layout of a cell architecture including functional transistor cell structures and ECO transistor cell structures in integrated circuit devices according to some embodiments of the present disclosure.
FIG. 2A is a schematic plan view diagram illustrating ECO and power tab regions of an ECO transistor cell structure according to some embodiments of the present disclosure.
FIG. 2B is a is a schematic plan view diagram illustrating example components and layout of ECO and power tab regions of an ECO transistor cell structure according to some embodiments of the present disclosure in greater detail.
FIG. 3A is a schematic cross-sectional view diagram illustrating an example ECO region of an ECO transistor cell structure including planar transistor structures according to some embodiments of the present disclosure.
FIG. 3B is a schematic cross-sectional view diagram illustrating an example power tab region of an ECO transistor cell structure including planar transistor structures according to some embodiments of the present disclosure.
FIG. 4A is a schematic cross-sectional view diagram illustrating an example ECO region of an ECO transistor cell structure including vertically stacked transistor structures according to some embodiments of the present disclosure.
FIG. 4B is a schematic cross-sectional view diagram illustrating an example power tab region of an ECO transistor cell structure including vertically stacked transistor structures according to some embodiments of the present disclosure.
FIG. 5A is a schematic plan view diagram illustrating example revised connections of an ECO transistor cell structure according to some embodiments of the present disclosure.
FIG. 5B is an equivalent circuit diagram illustrating the revised connections of FIG. 5A.
FIG. 6A is a schematic plan view diagram illustrating example revised connections of an ECO transistor cell structure according to some embodiments of the present disclosure.
FIG. 6B is an equivalent circuit diagram illustrating the revised connections of FIG. 6A.
FIG. 7A is a schematic plan view diagram illustrating example revised connections of an ECO transistor cell structure according to some embodiments of the present disclosure.
FIG. 7B is an equivalent circuit diagram illustrating the revised connections of FIG. 7A.
FIGS. 8A and 8B illustrate ECO transistor cell structures according to a comparative example before and after revision, respectively.

### DETAILED DESCRIPTION OF EMBODIMENTS

Example embodiments are described herein with reference to the accompanying drawings, which may include cross-section illustrations that are schematic illustrations of idealized embodiments (and intermediate structures). The sizes and relative sizes of layers and regions may be exaggerated for clarity. Additionally, variations from the shapes of the illustrations as a result, for example, of manufacturing techniques and/or tolerances, are to be expected. The same reference numerals may be used to refer to the same or similar elements in various embodiments, where reference numerals followed by a dash (-1, -2, etc.) or one or more prime symbols (') may refer to specific instances or variations of the same or similar elements.

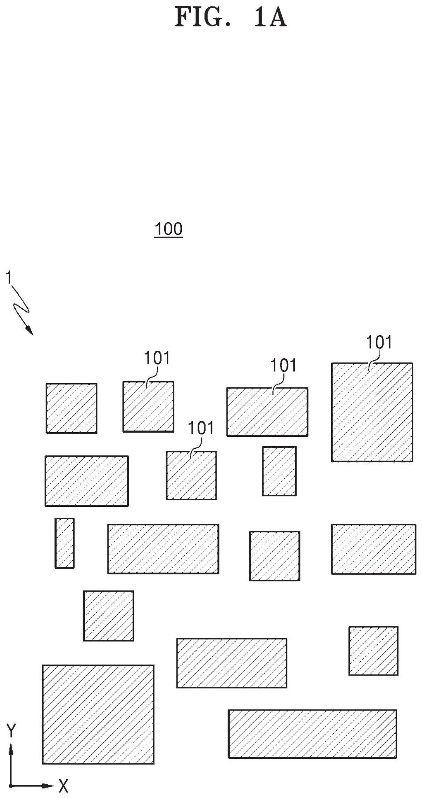

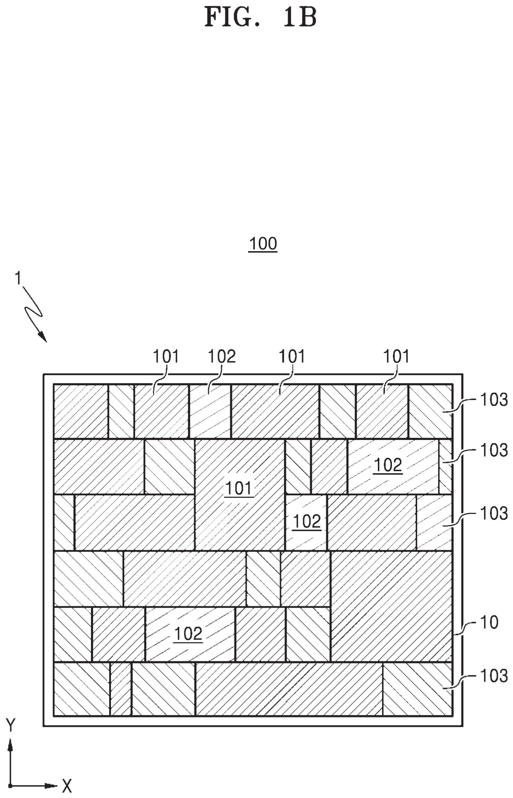

Some embodiments of the present disclosure are directed to integrated circuit devices including ECO cells interspersed or otherwise distributed among functional transistor cells of the integrated circuit devices. FIGS. 1A and 1B are schematic plan view diagrams illustrating design and layout of a cell architecture including functional transistor cell structures (also referred to as functional transistor cells) and ECO transistor cell structures (also referred to as ECO cells) in integrated circuit devices according to some embodiments of the present disclosure. Each of the functional transistor cells and ECO cells may include one or more components of a transistor (e.g., gates, source/drain regions, etc., also referred to as transistor structures) which may or may not be functional or operable as transistors (i.e., may or may not be configured to be switched between conducting and non-conducting states).

Referring now to FIG. 1A, the cell architecture may include a particular layout 1 for functional transistor cells 101 of an integrated circuit device 100. The functional transistor cells 101 are arranged along first and second horizontal directions (shown as the X- and Y- directions, respectively). The functional transistor cells 101 may include respective transistors that are configured to be switched between conducting and non-conducting states (e.g., to allow or prevent conduction of current between a source region and a drain region responsive to application of a voltage to a gate). The functional transistor cells 101 may be used to implement logic devices or memory devices, and may be supplied with power from a backside power delivery network (BSPDN).

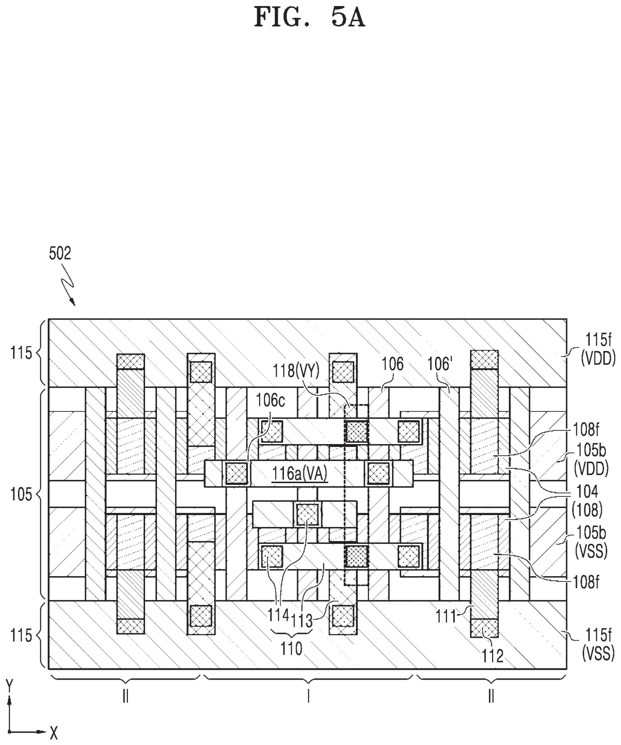

As shown in FIG. 1B, in order to implement changes or fixes after an initial design of the integrated circuit device has been completed, the integrated circuit device 100 may include a plurality of ECO cells (also referred to as ECO filler cells) 102 that are interspersed or otherwise distributed (along with other filler cells 103) among the functional transistor cells 101 on a substrate 10. As noted above, the ECO cells 102 are designed to be configurable, and may be modified or revised (by changing only a subset of layers or masks) to provide functional transistor cells 502, 602, 702 (see FIGS. 5A, 6A, and 7A). As such, prior to revision (e.g., in response to an engineering change order), the ECO cells 102 may be considered as including non-functional transistors (e.g., physically incomplete transistors) that cannot be switched between conducting and non-conducting states responsive to application of voltage or current.

The ECO cells 102 may provide several benefits, including cost efficiency, time savings, and flexibility. For example, rather than redesigning and remanufacturing a chip from scratch to implement changes (which can be extremely costly), the ECO cells 102 may allow for changes to be made with minimal additional cost by modifying only certain layers of a chip. Also, the ECO cells 102 may allow for incremental changes to be made, saving significant time compared to a full redesign (as the process for designing and fabricating a chip can require several months to a year). The ECO cells 102 may further provide flexibility to make targeted modifications to specific parts of a chip, addressing issues or adding features without affecting the entire design.

Some embodiments of the present disclosure may arise from realization that integrated circuit devices (including functional transistor cells and ECO cells as described above) typically are supplied power from a Back-Side Power Delivery Network (BSPDN). For example, the BSPDN may be provided in or on one or more bottom layers of a transistor structure to further improve the integration degree, power level, and performance of an integrated circuit device. In a vertically stacked transistor structure, the BSPDN may supply power to the upper transistor and/or the lower transistor. In some applications, power may need to be delivered between the BSPDN and a Front-Side Power Delivery Network (FSPDN) on an upper surface of the transistor structure. A middle-of-line (MOL) structure, including conductive vias and conductive contacts, may be used to provide electrical connectivity between the BSPDN and the FSPDN.

Even though BSPDN structures may provide multiple benefits such as source resistance reduction, implementation of the BSPDN structures may involve more aggressive process schemes and greater expense, including increased number of masks and associated process steps. BSPDN structures may be particularly problematic in ECO cells, as implementing revisions to the ECO cells may require revisions to not only frontside layers of the back end-of-line (BEOL) structure, but also revisions to backside (metal) layers of the BEOL structure, as well as revisions to the buried contact layers between the frontside and backside layers, thereby increasing cost and complexity of revising the ECO cells.

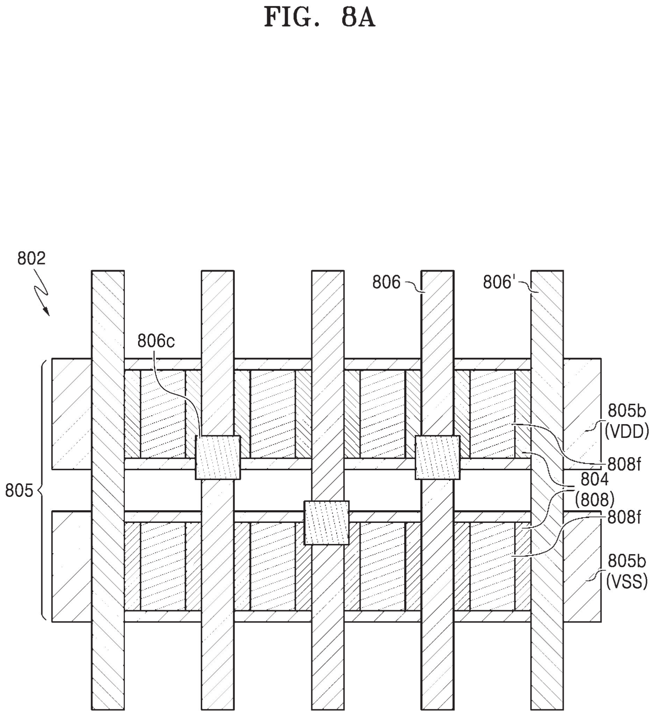

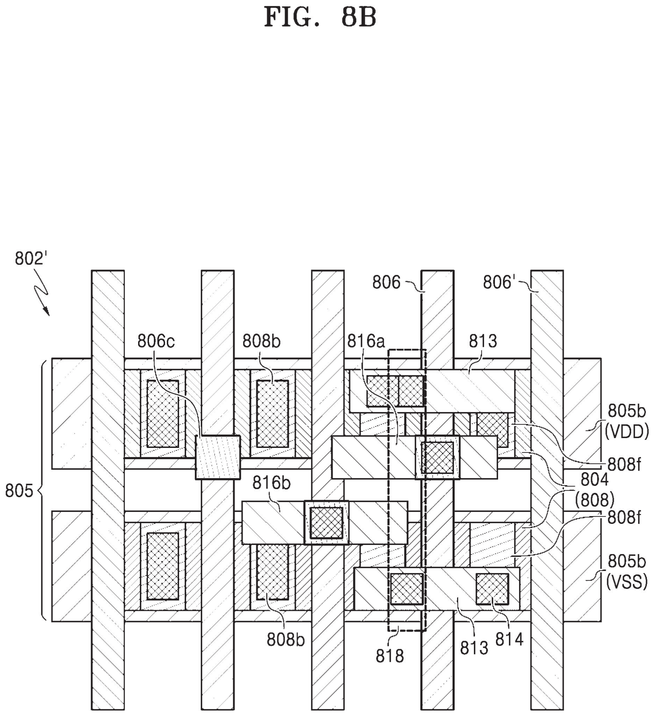

FIGS. 8A and 8B illustrate ECO cells 802 and 802' (before and after revision, respectively) according to a comparative examples. As shown in FIG. 8A, the ECO cell 802 includes a plurality of transistor structures 804 (shown as p-type and n-type field effect transistors (FETs) including gates 806, 806' and source/drain regions 808) that are supplied with power from an underlying BSPDN 805. The BSPDN 805 includes one or more backside metal lines (such as backside power rails 805b), which may be operable to provide a power supply voltage VDD or a reference voltage VSS. As shown in FIG. 8B, revisions to the ECO cell 802' may require (at least one among) frontside contacts 808f, frontside metal lines 813, frontside vias 814, input connections 816a, 816b, and output connections 818, as well backside contacts 808b to connect the transistor structures 804 to the underlying backside power rails 805b or other backside metal lines. That is, the transistor structures 804 are supplied power from the BSPDN 805. However, while the BSPDN 805 provides many benefits, it may make revisions to ECO cells 802 more difficult and expensive, for example, due to an increased number of masks that may be needed for revising connections at both frontside and backside metal layers of the ECO cells 802.

Embodiments of the present disclosure are directed to integrated circuit devices including cell architectures in which functional transistor cells are supplied with power primarily by BSPDNs, but ECO cells are supplied with power from FSPDNs. More particularly, the ECO cells include ECO regions that include an overlying FSPDN, and one or more power tab regions that provide electrical connection from the FSPDN to an underlying BSPDN. The power tab regions may be located adjacent (or overlapping) one or more sides of a cell boundary of a respective ECO cell. The ECO regions are thus free of overlap with underlying BSPDNs (and connections to backside power rails), such that only frontside layers (e.g., BEOL layers) of the ECO regions need be revised to provide functional transistor cells, and such that backside layers of the ECO cells need not be modified to implement revisions. As such, the transistor structures of the revised ECO cells are supplied with power from the FSPDN (rather than directly from the BSPDN), without modifying the backside layers of the integrated circuit device.

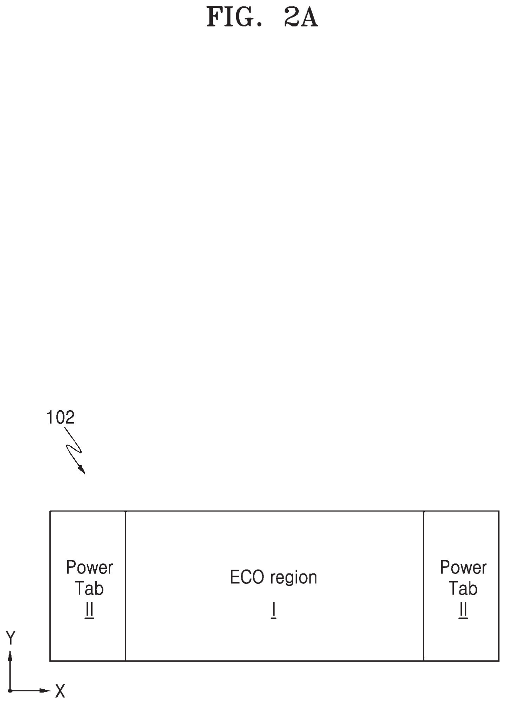

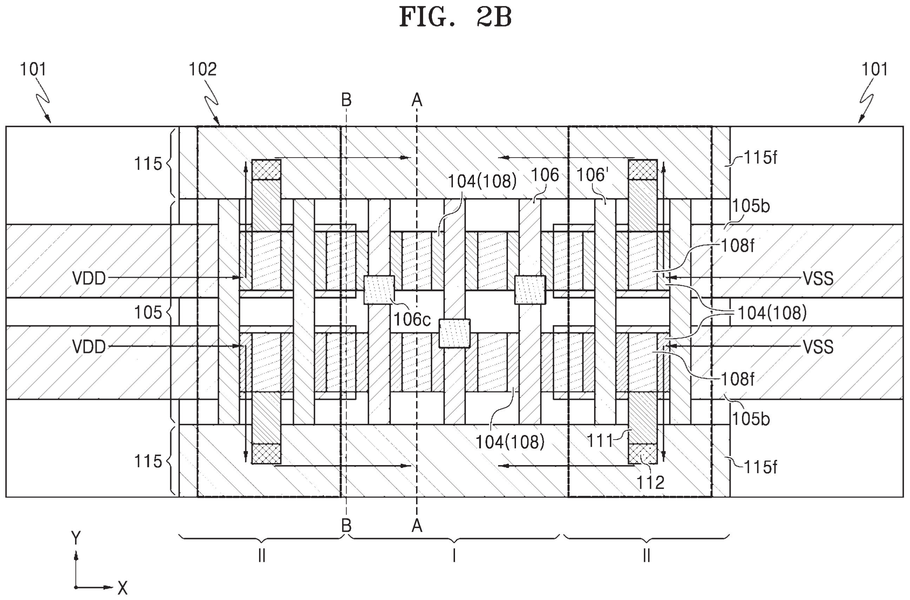

FIG. 2A is a schematic plan view diagram illustrating ECO region and power tab regions of an engineering change order (ECO) transistor cell structure (also referred to herein as an ECO cell) according to some embodiments of the present disclosure. As shown in FIG. 2A, an ECO transistor cell structure 102 of an integrated circuit device (such as the integrated circuit device 100 of FIG. 1B) includes a first region I and at least one second region II adjacent the first region. The first region I may be referred to as an ECO region. The ECO region I is configured to be revised based on an engineering change order, and includes transistor structures 104 that are configured to be supplied with power from an overlying FSPDN 115 (*see* FIG. 2B). The second region II may be referred to as a power tab region. The power tab region II is configured to electrically connect the overlying FSPDN 115 to a BSPDN 105 underlying the power tab region II. Although illustrated as being arranged adjacent opposing sides of the ECO region I in the X-direction, it will be understood that the power tab region II may be located adjacent (or overlapping) any side of the ECO region I (e.g., adjacent one or more sides of the ECO region in the Y-direction). Also, while two power tab regions II are illustrated, it will be understood that embodiments of the present disclosure may include other arrangements (e.g., with fewer or more power tab regions II adjacent fewer or more sides of the ECO region I). More generally, the ECO transistor cell structure 102 includes one or more laterally adjacent power tab regions II that respectively include conductive structures that electrically connect the BSPDN 105 to the FSPDN 115, such that the FSPDN can provide power to the ECO region I.

FIG. 2B is a is a schematic plan view diagram illustrating example components and layout of an ECO transistor cell structure according to some embodiments of the present disclosure in greater detail. As shown in FIG. 2B in greater detail, the ECO transistor cell structure 102 is stacked between the BSPDN 105 therebelow and the FSPDN 115 thereabove. The BSPDN 105 includes one or more backside power rails 105b (shown as two backside power rails that provide a power supply voltage VDD and a reference voltage VSS, respectively) longitudinally extending in a first direction (shown as the X-direction) under the ECO cell transistor structure 102. The FSPDN 115 includes one or more frontside power rails 115f (shown as two frontside power rails that provide a power supply voltage VDD and a reference voltage VSS, respectively) longitudinally extending in the first (e.g., X-) direction over the ECO transistor cell structure 102.

The ECO transistor cell structure 102 includes a first or ECO region I and a second or power tab region II that is adjacent the first region I (e.g., in the X-direction in FIG. 2B). In particular, the example of FIG.2B illustrates that a respective ECO region I includes two (2) power tab regions II on opposing sides or cell boundaries. The ECO transistor cell structure 102 further includes transistor structures 104 in the first and second regions I and II. Each transistor structure 104 may include one or more channel layers extending between source/drain regions 108. The source/drain regions 108 may be electrically connected to the channel layer(s). Each of the source/drain regions 108 may include a semiconductor layer (e.g., a silicon (Si) layer and/or a silicon germanium (SiGe) layer) and may additionally include dopants in the semiconductor layer. For example, each of source/drain regions 108 may include an epitaxial semiconductor layer having dopants (i.e., impurities) therein. A respective gate 106, 106' may extend on the channel layer(s) between the source/drain regions 108. For example, the gates 106, 106' may be metal or other conductive lines that longitudinally extend in a third direction (shown as the Y-direction) that intersects the extension direction (shown as the X-direction) of the power rails 105b, 115f.

The ECO region I is configured to be revised such that one or more transistor structures 104 thereof are electrically connected to the FSPDN 115, while the power tab region II electrically connects the FSPDN 115 to the BSPDN 105. As shown in FIG. 2B, the BSPDN 105 (and the backside power rails 105b thereof) extend under the power tab region II, but do not extend under the ECO region I. That is, the ECO region I of the ECO transistor cell structure 102 is free of overlap with the BSPDN 105 (and the backside power rails 105b) in a second or vertical direction (shown as the Z-direction), also referred to herein as vertical overlap. The FSPDN 115 (and the frontside power rails 115f thereof) extend (e.g., continuously) over the ECO region I and the power tab region II of the ECO transistor cell structure 102 in a horizontal (e.g., X-) direction, such that the FSPDN 115 overlaps the ECO and power tab regions I and II in the vertical (e.g., Z-) direction. The gates 106 in the ECO region I may be configured to be revised to provide input signals to the transistor structures 104, while the gates 106' in the power tab region II may be dummy gates that are not configured to provide input signals to the transistor structures 104.

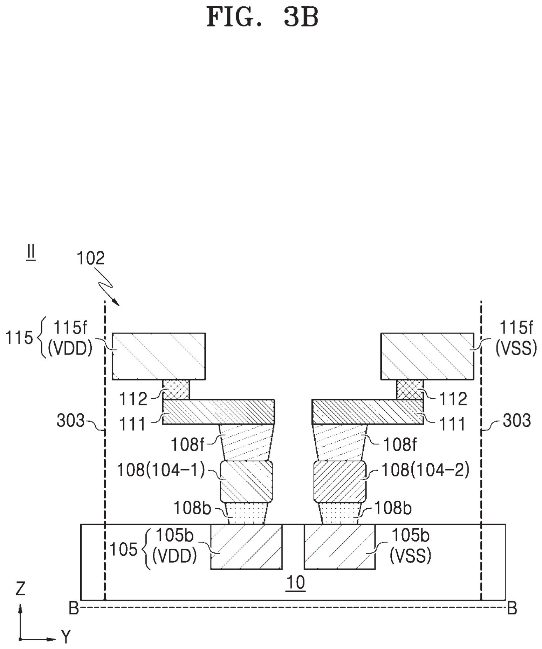

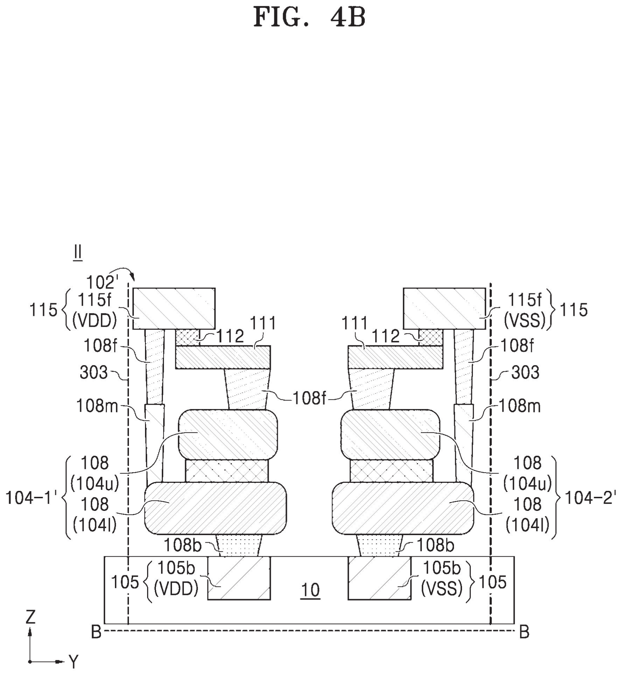

The power tab region II of the ECO transistor cell structure 102 overlaps the backside power rail 105b in the second direction Z, and includes one or more conductive elements (e.g., 108f, 108b (not visible in FIG. 2B), 111, 112; see FIG. 3B and 4B) that electrically connect each backside power rail 105b to a respective frontside power rail 115f (with the conductive path from the backside power rails 105b through the (frontside) conductive lines 111 and (frontside) vias 112 to the frontside power rail 115f shown by arrows in FIG. 2B). That is, the power tab region II of the ECO transistor cell structure 102 is configured to supply power from the backside power rail 105b to the frontside power rails 115f, such that that, upon revision, the transistor structures 104 of the first region I of the ECO transistor cell structure 102 can be supplied with power from the frontside power rails 115f (rather than directly from the backside power rails 105b). The frontside power rails 115f of the FSPDN 115 may not vertically overlap the backside power rails 105b of the BSPDN 105 in the second region II (the power tab region II) in some embodiments.

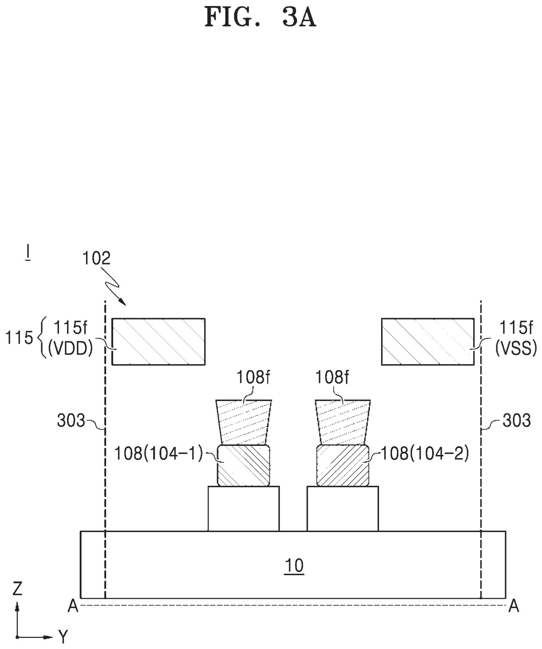

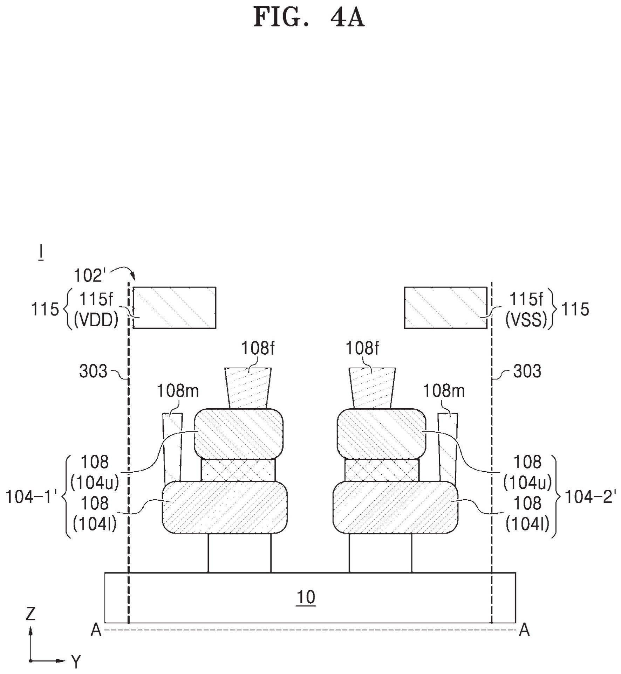

The power tab region II is thereby configured to transfer power from BSPDN 105 to FSPDN 115. Even though the power for the transistor structures 104 of the ECO region I is provided by the BSPDN 105 (via the FSPDN 115), the backside power rails 105b of the BSPDN 105 do not extend into the ECO region I, such that the ECO region I is free of conductive elements or layers under the transistor structures 104 (*see* FIGS. 3A and 4A) and thus cannot be revised to directly contact the BSPDN 105. That is, the ECO region I only includes the frontside power rails 115f of the FSPDN 115, and the transistor structures 104 of the ECO region I can only be supplied power through the FSPDN 115.

As such, if engineering revisions are proposed, the ECO transistor cell structure 102 can be used to implement functional transistor structures 104 by revising only frontside layers (i.e., by providing conductive elements between transistor structures 104 and/or between the transistor structures 104 and the frontside power rails 115f, without altering backside layers and/or without providing additional connections to the backside power rails 105b (beyond those already provided in the power tab region II). In other words, revisions to backside layers (such as backside contacts (buried contacts) 108b) are not needed to revise the transistor structures 104 of the ECO region I, thereby reducing the number of masks (and associated fabrication operations) and risks (with respect to altering connections to the BSPDN and associated reliability issues) of the revision process.

Referring back to FIG. 1B, the ECO transistor cell structure 102 is arranged laterally adjacent (i.e., side-by-side) one or more functional transistor cell structures 101 in the first direction X and/or the third direction Y. The functional transistor cell structures 101 (also referred to as second transistor structures) include transistor structures 104 that are electrically connected to the backside power rail 105b by respective backside contacts 108b. That is, the transistor structures 104 of the functional transistor cell structures 101 are supplied power from the BSPDN 105. The functional transistor cell structures 101 may overlap the backside power rails 105b in the second direction Z. For example, the backside power rails 105b may continuously extend in the first (e.g., X-) direction from under the second region II of the ECO transistor cell structures 102 to under the functional transistor cell structures 101.

In some embodiments, the transistor structures 104 of the functional transistor cell structures 101 may be free of frontside contacts 108f that are electrically connected to the frontside power rail 115f. For example, the functional transistor cell structures 101 may be free of overlap with the frontside power rail 115f in the vertical (e.g., Z-) direction in some embodiment. In some embodiments, the frontside power rails 115f may not continuously extend in the first (e.g., X-) direction from the ECO transistor cell structures 102 into the functional transistor cell structures 101. That is, the transistor structures 104 of the functional transistor cell structures 101 may be configured to be supplied with power from the BSPDN 105, but not from the FSPDN 115.

FIGS. 3A and 3B are schematic cross-sectional view diagrams illustrating an example ECO region I and an example power tab region II, respectively, of an ECO transistor cell structure 102 according to some embodiments of the present disclosure. In particular, the cross-sectional views shown in FIGS. 3A and 3B are taken along lines A-A and B-B, respectively, of FIG. 2B. The ECO region I and the power tab region II of the ECO transistor cell structure 102 include transistor structures 104-1 and 104-2 (collectively, 104), each having source/drain regions 108 and a gate (not shown) on a channel region (not shown) between the source/drain regions 108. In FIGS. 3A and 3B, the transistor structures 104-1 and 104-2 are shown as a planar p-type FET (PFET) and a planar n-type FET (NFET), respectively. The transistor structures 104-1 and 104-2 are provided between an overlying FSPDN 115 and an underlying BSPDN 105 on a substrate 10. The substrate 10 may include a semiconductor material such as silicon and/or insulating materials. For example, the insulating materials may include silicon oxide, silicon oxynitride, silicon nitride, silicon carbonitride, silicon boron nitride and/or a low-k dielectric material, such as fluorine-doped silicon oxide, organosilicate glass, carbon-doped oxide, porous silicon dioxide, porous organosilicate glass, spin-on organic polymeric dielectrics and/or spin-on silicon based polymeric dielectrics.

As shown in FIGS. 3A and 3B, frontside power rails 115f of the FSPDN 115 are provided at an upper portion of the ECO region I and the power tab region II of the ECO transistor cell structure 102. As shown in FIG. 3B, backside power rails 105b of the BSPDN 105 are provided at a lower portion of the power tab region II of the ECO transistor cell structure 102, but do not extend into (i.e., do not vertically overlap) the first region I (the ECO region I), as shown in FIG. 3A. The frontside power rails 115f and the backside power rails 105b are spaced apart and may be between cell boundaries 303 in a horizontal (e.g., Y-) direction. However, embodiments of the present disclosure are not limited thereto, and the frontside power rails 115f and/or the backside power rails 105b may overlap the cell boundaries 303 in the vertical (e.g., Z-) direction in some embodiments. Although two (2) frontside power rails 115f and two (2) backside power rails 105b are illustrated between the cell boundaries 303 by way of example, the number of frontside power rails 115f and backside power rails 105b is not limited thereto.

In some embodiments, the frontside power rails 115f and the backside power rails 105b may include a conductive material, such as a metal. For example, the frontside power rails 115f and the backside power rails 105b may include copper, aluminum, and/or tungsten, but not limited thereto. The frontside power rails 115f may be formed in a first front metallization layer (M1) of the integrated circuit device 100. The backside power rails 105b may be formed in a first back metallization layer (BM1) of the integrated circuit device 100. Additional metallization layers (e.g., M2 and BM2) may be stacked on the metallization layers M1 and BM1 in the vertical (e.g., Z-) direction, respectively. Although not illustrated, one or more interlayer insulating layers may extend around (e.g., at least partially surround) frontside power rails 115f and the backside power rails 105b. In the example of FIG. 3B, the frontside power rails 115f do not overlap the backside power rails 105b in the vertical (e.g., Z-) direction, and are laterally spaced apart from the backside power rails 105b in a horizontal (e.g., Y-) direction. However, in other embodiments, the frontside power rails 115f may partially or completely overlap the backside power rails 105b in the vertical (e.g., Z-) direction.

Still referring to FIGS. 3A and 3B, the ECO transistor cell structure 102 may further include middle-of-line (MOL) structures. The MOL structures may include interlayer insulating layer(s) in which conductive wire(s) (e.g., metal wire(s)), conductive via(s) (e.g., metal via(s)), and/or conductive contact(s) (e.g., metal contact(s)) are provided. For example, the MOL structure may include frontside contacts 108f (also referred to as epitaxial layer contacts), and backside contacts 108b (also referred to as a direct back-side contacts (DBC)). However, the MOL structures are not limited to the embodiments described above. For example, the MOL structures may include additional elements, or some of the elements of the MOL structures described above may be omitted or integrated with each other.

While not present in the ECO region I (as shown in FIG. 3A), the BSPDN 105 (including backside power rails 105b and/or other backside metal lines) may be configured to supply power to the FSPDN 115 in the power tab region II (as shown in FIG. 3B). In particular, in the power tab region II shown in FIG. 3B, the frontside power rails 115f are electrically connected to respective backside power rails 105b (e.g., through a source/drain region 108 of at least one of the transistor structures 104-1 and 104-2 and one or more of the MOL conductive structures). For example, the source/drain regions 108 of each of the transistor structures 104-1 and 104-2 in the power tab region II may be directly connected to respective backside power rails 105b (which may provide a supply voltage VDD and a reference voltage VSS, respectively) through respective backside contacts 108b in a DBC scheme. The source/drain regions 108 of each of the transistor structures 104-1 and 104-2 may also include frontside contacts 108f thereon opposite the backside contacts 108b. One or more conductive elements (shown as frontside conductive lines 111 and frontside vias 112 in respective frontside BEOL layers) electrically connect the frontside contacts 108f in the power tab region II to the frontside power rail 115f. However, it will be understood that the configurations of the conductive elements 111, 112 is not limited to those illustrated.

As shown in FIG. 3B, the BSPDN 105 may thereby be electrically connected to the FSPDN 115 through at least one among the transistor structures 104-1 and 104-2 (e.g., at least one of the source/drain regions 108), the MOL structures 108b, 108f, and the conductive elements 111, 112. That is, the planar transistors 104-1 and 104-2 in the second region II may provide power tab structures, with the source/drain regions 108 thereof providing through-epi contacts to deliver power from the BSPDN 105 to the FSPDN 115, such that the FSPDN 115 may be configured to supply power to transistor structures 104-1 and 104-2 of the first region I. In some embodiments, the FSPDN 115 and the BSPDN 105 may be in different power domains. For example, the FSPDN 115 may provide a local power distribution network among the ECO transistor cell structures 102, while the BSPDN 105 may be a global power distribution network for some or all of the functional transistor cells 101 (and/or the ECO transistor cell structures 102) of the integrated circuit device 100.

Referring again to FIG. 3A, the transistor structures 104-1 and 104-2 in the ECO region I may also include frontside contacts 108f on respective source/drain regions 108 adjacent the FSPDN 115 (i.e., adjacent the frontside power rails 115f). However, the source/drain regions 108 of the transistor structures 104-1 and 104-2 in the ECO region I may be free of backside contacts 108b thereon opposite the frontside contacts 108f. Moreover, the backside power rails 105b of the BSPDN 105 do not extend under the first region I of the ECO transistor cell structure 102. That is, the transistor structures 104-1 and 104-2 of the first region I of the ECO transistor cell structure 102 are free of a backside contacts 108b that electrically connect the source/drain regions 108 thereof to the BSPDN 105. More generally, the first region I of the ECO transistor cell structure 102 is free of conductive structures in respective layers of the ECO transistor cell structure 102 (e.g., backside BEOL layers) below the transistor structures 104-1 and 104-2. As shown in FIG. 3A, the frontside contacts 108f (and gate contacts; not shown) in the ECO region I are likewise electrically isolated from the frontside power rails 115f, but respective layers of the ECO transistor cell structure 102 that are between the frontside power rail 115f and the frontside contacts 108f are configured to be revised to provide electrical connections between one or more of the frontside contacts 108f and the frontside power rails 115f in the ECO region I, as described in greater detail below with reference to FIGS. 5A, 6A, and 7A.

FIGS. 4A and 4B are schematic cross-sectional view diagrams illustrating an example ECO region I and an example power tab region II, respectively, of an ECO transistor cell structure 102' according to some embodiments of the present disclosure. In particular, the cross-sectional views shown in FIGS. 4A and 4B are taken along lines A-A and B-B, respectively, of FIG. 2B. The ECO region I and the power tab region II of the ECO transistor cell structure 102' include transistor structures 104-1' and 104-2' (collectively, 104'), each having source/drain regions 108 and a gate (not shown) on channel regions (not shown) that extend between the source/drain regions 108. In FIGS. 4A and 4B, the transistor structures 104-1' and 104-2' are implemented as vertically stacked transistor structures, each including an upper transistor structure 104u that is stacked on a lower transistor structure 104I (of the same or opposite conductivity type) in a vertical (e.g., Z-) direction (shown as a PFET stacked on an NFET by way of example).

The stacked transistor structures 104' of FIGS. 4A and 4B are arranged in an L-shaped scheme, where the upper and lower transistor structures 104u and 104I have different widths in a horizontal (e.g., Y-) direction. In the L-shaped scheme, one of the sidewalls of the upper transistor structure 104u and one of sidewalls of the lower transistor structure 104I may be aligned, and another one of the sidewalls of the upper transistor structure 104u and another one of the sidewalls of the lower transistor structure 104I may not be aligned in the vertical direction. However, it will be understood that the stacked transistor structures 104' may be arranged in other schemes, such as an I-shaped scheme (where the upper and lower transistor structures 104u and 104I have substantially similar widths in a horizontal (e.g., Y-) direction), or a Z-shaped scheme (where the upper and lower transistor structures 104u and 104I are offset in a horizontal (e.g., Y-) direction). In the Z-shaped scheme, one of the sidewalls of the lower transistor structure 104I may overlap the upper transistor structure 104u in the vertical direction, and another one of the sidewalls of the lower transistor structure 104I may not overlap the upper transistor structure 104u in the vertical direction.

The ECO transistor cell structure 102' of FIGS. 4A and 4B may otherwise be similar to those of the ECO transistor cell structure 102 of FIGS. 3A and 3B. As such, the BSPDN 105 (including backside power rails 105b and/or other backside metal lines) may not be present in the ECO region I (as shown in FIG. 4A), but may be configured to supply power to the FSPDN 115 in the power tab region II (as shown in FIG. 4B). In particular, in the power tab region II shown in FIG. 4B, the frontside power rails 115f are electrically connected (e.g., through a source/drain region 108 of at least one among the lower transistor structures 104I and one or more of MOL conductive structures) to backside power rails 105b. For example, the source/drain regions 108 of each of the lower transistor structures 104I may be directly connected to respective backside power rails 105b (which may provide a supply voltage VDD and a reference voltage VSS, respectively) through respective backside contacts 108b in a DBC scheme. The source/drain regions 108 of each of the lower transistor structures 104I may also include middle contacts 108m and frontside contacts 108f thereon opposite the backside contacts 108b. One or more additional conductive elements (shown frontside conductive lines 111 and frontside vias 112) may also electrically connect the upper transistor structures 104u in the power tab region II to the frontside power rail 115f in some embodiments.

Similar to the embodiment of FIG. 3A, the transistor structures 104-1' and 104-2' in the ECO region I of FIG. 4A may also include frontside contacts 108f on respective source/drain regions 108 of the upper transistor structures 104u and/or the lower transistor structures 104I adjacent the FSPDN 115 (i.e., adjacent the frontside power rails 115f). However, the source/drain regions 108 of the lower transistor structures 104I in the ECO region I may be free of backside contacts 108b thereon opposite the frontside contacts 108f. Moreover, the backside power rails 105b of the BSPDN 105 do not extend under the first region I of the ECO transistor cell structure 102', such that the transistor structures 104' of the first region I of the ECO transistor cell structure 102' are free of a backside contacts 108b (or other conductive structures) that electrically connect the source/drain regions 108 thereof to the BSPDN 105 in respective layers of the ECO transistor cell structure 102' below the transistor structures 104'. However, as shown in FIG. 4A, while the frontside contacts 108f (and the gate contacts) in the ECO region I are likewise electrically isolated from the frontside power rails 115f, respective layers of the ECO transistor cell structure 102' that are between the frontside power rail 115f and the frontside contacts 108f are configured to be revised to provide electrical connections between one or more of the frontside contacts 108f and the frontside power rails 115f of the ECO region I, as described in greater detail below with reference to the examples of FIGS. 5A, 6A, and 7A.

It will be understood that, prior to revision as described herein, the transistor structures 104, 104' of the ECO region I (and the power tab region(s) II) of the ECO transistor cell structures 102, 102'may be non-functional (or incomplete) (i.e., may not be capable of being switched between conducting and non-conducting states responsive to a control signal applied to the gates 106). However, the transistor structures 104, 104' may be structurally similar or identical to the transistor structures of the functional transistor cells 101 of FIG. 1B. As such, responsive to revision (e.g., in response to an engineering change order), the transistor structures 104, 104' of the ECO region I may be reconfigured as functional transistors that can be switched between conducting and non-conducting states, e.g., to implement logic devices or memory devices. In contrast, the transistor structures 104, 104' of the power tab region(s) II may not be reconfigured responsive to an engineering change order in some embodiments. That is, revised ECO cells (e.g., 502, 602, 702) described herein may include revisions to frontside BEOL layers in the ECO region I, but may not include revisions to frontside BEOL layers in the power tab region(s) II.

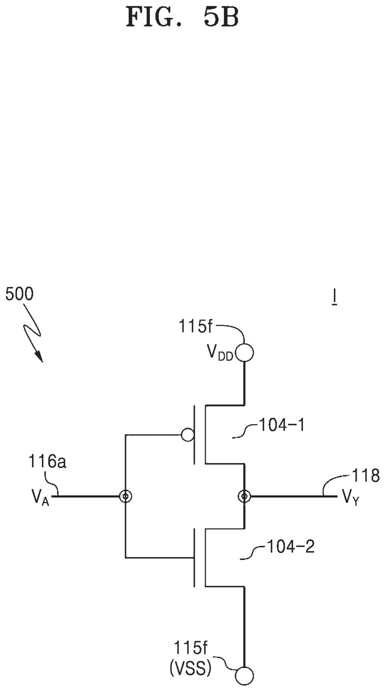

FIG. 5A is a schematic plan view diagram illustrating example revised connections of an ECO transistor cell structure according to some embodiments of the present disclosure. FIG. 5B is an equivalent circuit diagram illustrating the revised connections of FIG. 5A. In particular, FIGS. 5A and 5B illustrate a revised ECO transistor cell structure 502 that implements a CMOS inverter circuit 500.

As shown in FIG. 5A, the revised ECO transistor cell structure 502 is provided by revising or altering one or more frontside layers (e.g., frontside BEOL structures) at upper portions of the first region I of the ECO transistor cell structure 102 of FIG. 2B, but without altering backside layers (e.g., backside BEOL structures) at lower portions thereof. The revisions include providing revised conductive structures 110 (including conductive lines 113 and conductive vias 114) that electrically connect the first (e.g., PFET) transistor structure 104-1 and the second (e.g., NFET) transistor structure 104-2 in series between the frontside power rails 115f. In particular, the revised conductive structures 110 electrically connect an input connection 116a (V_{A}) to a gate 106; electrically connect one source/drain region 108 of transistor structure 104-1 to a frontside power rail 115f that provides a supply voltage VDD; electrically connect one source/drain region 108 of a transistor structure 104-2 to a frontside power rail 115f that provides a reference voltage VSS; and electrically connect the other source/drain regions 108 of the transistor structures 104-1 and 104-2 to an output connection 118 (Vy).

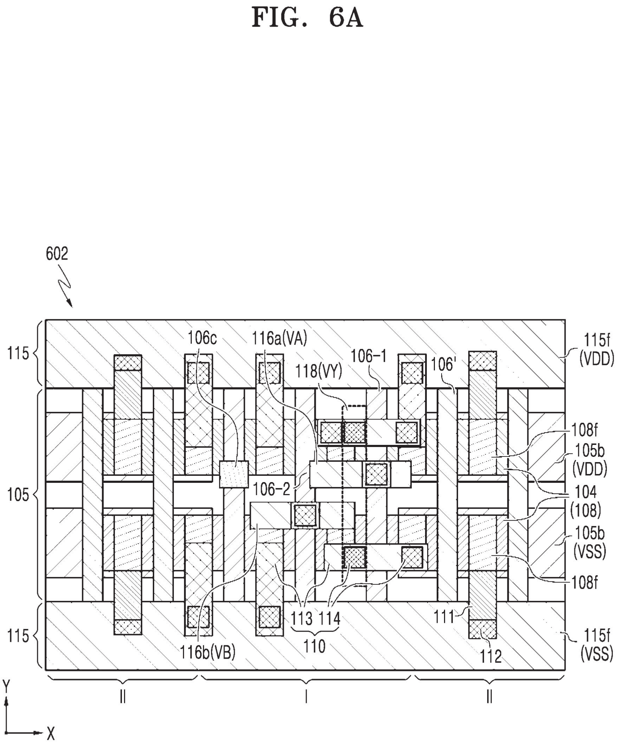

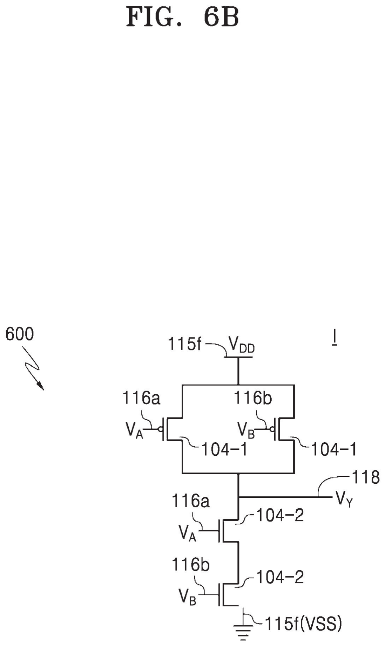

FIG. 6A is a schematic plan view diagram illustrating example revised connections of an ECO transistor cell structure according to some embodiments of the present disclosure. FIG. 6B is an equivalent circuit diagram illustrating the revised connections of FIG. 6A. In particular, FIGS. 6A and 6B illustrate a revised ECO transistor cell structure 602 that implements a two-input (shown as V_{A} and V_{B}) CMOS NAND circuit 600.

As shown in FIG. 6A, the revised ECO transistor cell structure 602 is provided by revising or altering one or more frontside layers (e.g., frontside BEOL structures) at upper portions of the first region I of the ECO transistor cell structure 102 of FIG. 2B, but without altering backside layers (e.g., backside BEOL structures) at lower portions thereof. The revisions include providing revised conductive structures 110 (including conductive lines 113 and conductive vias 114) that electrically connect two first (e.g., PFET) transistor structures 104-1 in parallel and electrically connect two second (e.g., NFET) transistor structures 104-2 in series between the frontside power rails 115f. In particular, the revised conductive structures 110 electrically connect an input connections 116a (V_{A}) and 116b (V_{B}) to a first gate 106-1 and a second gate 106-2, respectively; electrically connect one source/drain region 108 of each of the two first transistor structures 104-1 to a frontside power rail 115f that provides a supply voltage VDD; electrically connect the other source/drain region 108 of each of the two first transistor structures 104-1 to an output connection 118 (V_{Y}); and electrically connect the respective source/drain regions 108 of the two second transistor structures 104-2 such that the two second transistor structures 104-2 are in series between the output connection 118 (V_{Y}) and a frontside power rail 115f that provides a reference voltage VSS.

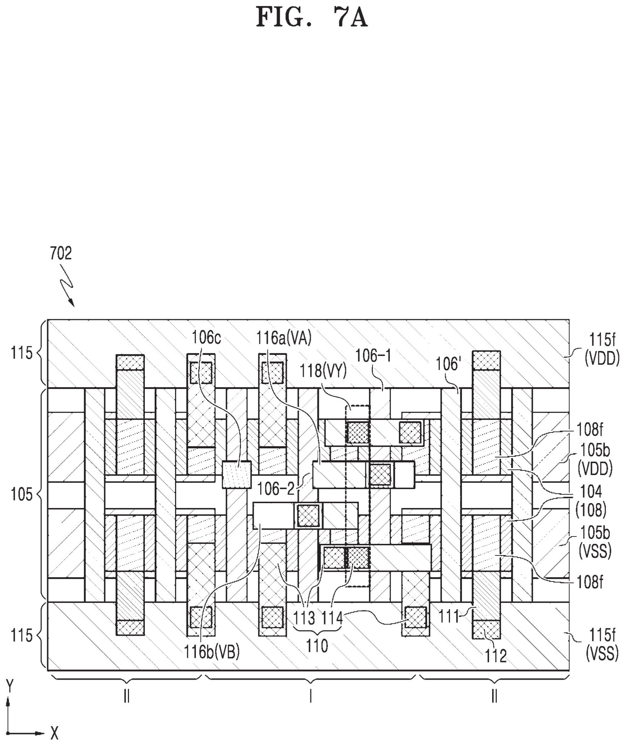

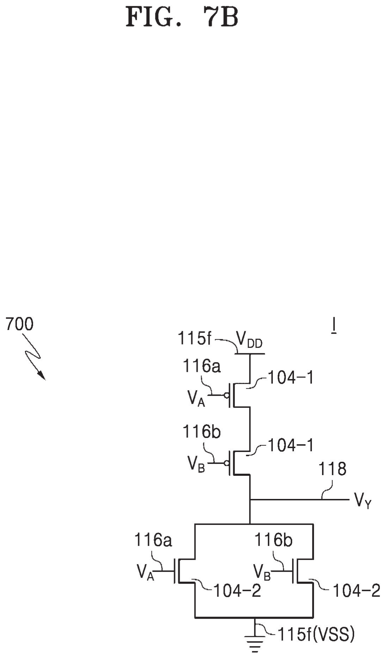

FIG. 7A is a schematic plan view diagram illustrating example revised connections of an ECO transistor cell structure according to some embodiments of the present disclosure. FIG. 7B is an equivalent circuit diagram illustrating the revised connections of FIG. 7A. In particular, FIGS. 7A and 7B illustrate a revised ECO transistor cell structure 702 that implements a two-input (shown as V_{A} and V_{B}) CMOS NOR circuit 700.

As shown in FIG. 7A, the revised ECO transistor cell structure 702 is provided by revising or altering one or more frontside layers (e.g., frontside BEOL structures) at upper portions of the first region I of the ECO transistor cell structure 102 of FIG. 2B, but without altering backside layers (e.g., backside BEOL structures) at lower portions thereof. The revisions include providing revised conductive structures 110 (including conductive lines 113 and conductive vias 114) that electrically connect two first (e.g., PFET) transistor structures 104-1 in series and electrically connect two second (e.g., NFET) transistor structures 104-2 in parallel between the frontside power rails 115f. In particular, the revised conductive structures 110 electrically connect input connections 116a (V_{A}) and 116b (V_{B}) to a first gate 106-1 and a second gate 106-2, respectively; electrically connect respective source/drain regions 108 of the two first transistor structures 104-1 such that the two first transistor structures 104-1 are in series between a frontside power rail 115f that provides a supply voltage VDD and an output connection 118 (V_{Y}); electrically connect one source/drain region 108 of each of the two second transistor structures 104-2 to the output connection 118 (V_{Y}); and electrically connect the other source/drain region 108 of each of the two second transistor structures 104-2 to a frontside power rail 115f that provides a reference voltage VSS.

In the examples of FIGS. 5A, 6A, and 7A, the frontside power rails 115f do not overlap the frontside contacts 108f in the vertical (e.g., Z-) direction and are laterally spaced apart therefrom in a horizontal (e.g., Y-) direction that intersects the horizontal (e.g., X-) direction of extension of the frontside power rails 115f. The revised conductive structures 110 include conductive vias 114 on the frontside power rails 115f and/or between other metal layers, conductive lines 113 extending in the X-direction, and/or conductive lines 113 extending in the Y-direction. The conductive vias 114, the frontside power rails 115f, the conductive lines 113, and the frontside contacts 108f are in different layers of the revised ECO transistor cell structures 502, 602, 702.

More particularly, the conductive vias 114 and conductive lines 113 are implemented in respective layers of the ECO transistor cell structure 102 that are above the frontside contacts 108f. For example, the conductive lines 113 and the conductive vias 114 may be frontside BEOL structures, which are provided in respective layers of the revised ECO transistor cell structure 502 that are between the frontside power rail 115f and the frontside contact 108f. The input connections 116a (V_{A}) and/or 116b (V_{B}) may be provided on an upper metallization layer (e.g., M1 or M2), while the output connection 118 (V_{Y}) may be provided on a lower metallization layer (e.g., BM1, BM2) in some embodiments. As such, only frontside metal layers (e.g., frontside BEOL structures) in the ECO region I need be revised to provide functional transistor cells (e.g., to provide logic circuits 500, 600, 700), while backside metal layers (e.g., backside BEOL structures) in the ECO region I of the revised ECO transistor cell structure 502, 602, 702 (as well as MOL structures and/or front end-of-line (FEOL) structures thereof) need not be modified to implement revisions. The transistor structures 104 of the revised ECO transistor cell structure 502, 602, 702 are supplied with power from the FSPDN 115 only, with no direct connections to the BSPDN 105. Also, as the power tab region(s) II are configured to provide power from the backside power rails 105b (which are confined in the power tab region(s) II and do not extend into the ECO region I) to the frontside power rails 115f, the power tab region(s) II need not be modified to implement the revisions to provide the CMOS inverter circuit 500, the CMOS NAND circuit 600, or the CMOS NOR circuit 700.

ECO transistor cell structures 102 according to embodiments of the present disclosure may thereby reduce costs (e.g., with respect to the revised number of masks required and the associated process steps) and process risks (e.g., with respect to introducing errors or defects associated with backside layer modification). Drawbacks of ECO transistor cell structures described herein may include additional footprint or area for providing the power tab regions II, and/or possible performance impacts by routing power from the BSPDN to the FSPDN in the ECO region I.

The disclosure herein is presented to enable one of ordinary skill in the art to make and use the disclosure and to incorporate it in the context of particular applications. While the foregoing is directed to specific examples, other and further examples may be devised without departing from the basic scope thereof.

Various modifications, as well as a variety of uses in different applications will be readily apparent to those skilled in the art, and the general principles defined herein may be applied to a wide range of embodiments. Thus, the present disclosure is not intended to be limited to the embodiments presented, but is to be accorded the widest scope consistent with the principles and novel features disclosed herein.

In the description provided, numerous specific details are set forth in order to provide a more thorough understanding of the present disclosure. However, it will be apparent to one skilled in the art that the present disclosure may be practiced without necessarily being limited to these specific details. In other instances, well-known structures and devices are shown in block diagram form, rather than in detail, in order to avoid obscuring the present disclosure.

All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Unless otherwise defined, all terms used herein have the same meaning as commonly understood by one of ordinary skill in the art. Further, all terms should be interpreted as having a meaning that is consistent with their meaning in the context of the relevant art and this disclosure and will not be interpreted in an idealized or overly formal sense unless expressly so defined herein.

In the description above, example embodiments may be described with reference to regions of particular conductivity types. It will be appreciated that opposite conductivity type devices may be formed by simply reversing the conductivity of the n-type and p-type layers in each of the above embodiments. Thus, it will be appreciated that the present disclosure covers both n-channel and p-channel devices for each different device structure.

The terminology used herein is for the purpose of describing particular embodiments only and is not intended to be limiting of embodiments. The singular forms "a," "an," and "the" are intended to include the plural forms as well, unless the context clearly indicates otherwise. The terms "comprises," "comprising," "includes" and/or "including" specify the presence of the stated features, steps, operations, elements, components and/or groups, but do not preclude the presence or addition of one or more other features, steps, operations, elements, components and/or groups thereof.

It will be understood that, although the terms "first," "second," etc. may be used throughout this specification to describe various elements, these elements should not be limited by these terms. Rather, these terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

The terms "surround" or "cover" or "fill" as used herein may not require completely surrounding or covering or filling the described elements or layers, but may, for example, refer to partially surrounding or covering or filling the described elements or layers. Components or layers described with reference to "overlap" in a particular direction may be at least partially obstructed by one another when viewed along a line extending in the particular direction or in a plane perpendicular to the particular direction.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. The term "connected" may include physical and/or electrical connections.

Spatially relative terms such as "below" or "above" or "upper" or "lower" or "top" or "bottom" or "side" may be used herein to describe a relationship of one element, layer or region to another element, layer or region based on a frame of reference (e.g., a substrate), as illustrated in the figures. It will be understood that these terms are intended to encompass different orientations of the device in addition to the orientation depicted in the figures. As used herein, the terms "frontside" and "backside" may refer to opposite sides (e.g., top and bottom) of an integrated circuit device, with frontside layers or structures being above the transistor structures, and backside layers or structures being below the transistor structures as shown in the figures.

Example embodiments are described herein with reference to the accompanying drawings, which may include cross-section illustrations that are schematic illustrations of idealized embodiments (and intermediate structures). Many different forms and embodiments are possible without deviating from the teachings of this disclosure. Accordingly, the present disclosure should not be construed as limited to the example embodiments set forth herein. As such, it will be understood by those of ordinary skill in the art that various changes in form and details may be made therein without departing from the scope as defined herein. In the drawings, the sizes and relative sizes of layers and regions may be exaggerated for clarity. Additionally, variations from the shapes of the illustrations as a result, for example, of manufacturing techniques and/or tolerances, are to be expected.

## Claims

1. An integrated circuit device (100), comprising:
an engineering change order, ECO, transistor cell structure (102) comprising a first region (I) and a second region (II) adjacent the first region (I); and
a backside power rail (105b) extending in a first direction (X) under the second region (II) of the ECO transistor cell structure (102),
wherein the first region (I) of the ECO transistor cell structure (102) is free of overlap with the backside power rail (105b) in a second direction (Y) that is perpendicular to the first direction (X).

2. The integrated circuit device (100) of Claim 1, further comprising:
a frontside power rail (115f) extending in the first direction (X) over the ECO transistor cell structure (102),
wherein the frontside power rail (115f) overlaps the first region (I) and the second region (II) of the ECO transistor cell structure (102) in the second direction (Y).

3. The integrated circuit device (100) of Claim 2, wherein the second region (II) of the ECO transistor cell structure (102) overlaps the backside power rail (105b) in the second direction (Y), and comprises one or more conductive elements (108f, 108b) that electrically connect the backside power rail (105b) to the frontside power rail (115f).

4. The integrated circuit device (100) of Claim 3, wherein the second region (II) of the ECO transistor cell structure (102) includes a source/drain region (108), and wherein the one or more conductive elements comprise:
a backside contact (108b) on the source/drain region (108), wherein the backside contact (108b) electrically connects the source/drain region (108) to the backside power rail (105b); and
a frontside contact (108f) on the source/drain region (108) opposite the backside contact (108b), wherein the frontside contact (108f) electrically connects the source/drain region (108) to the frontside power rail (115f).

5. The integrated circuit device (100) of Claim 4, wherein the frontside power rail (115f) does not overlap the backside power rail (105b) in the second direction (Y) and is spaced apart therefrom in a third direction that intersects the first direction (X), and wherein the one or more conductive elements further comprise:
a conductive via (112) on the frontside power rail (115f); and
a conductive line (111) extending in the third direction and electrically connecting the conductive via (112) to the frontside contact (108f).

6. The integrated circuit device (100) of Claim 2, wherein the first region (I) of the ECO transistor cell structure (102) comprises:
a source/drain region (108); and
a frontside contact (108f) on the source/drain region (108) adjacent the frontside power rail (115f),
wherein the source/drain region (108) is free of a backside contact (108b) thereon opposite the frontside contact (108f).

7. The integrated circuit device (100) of Claim 6, wherein the frontside contact (108f) is electrically isolated from the frontside power rail (115f).

8. The integrated circuit device (100) of Claim 6 or 7, wherein the first region (I) of the ECO transistor cell structure (102) further comprises at least one revised conductive structure (110) that electrically connects the frontside contact (108f) to the frontside power rail (115f).

9. The integrated circuit device (100) of Claim 8, wherein the frontside power rail (115f) does not overlap the frontside contact (108f) in the second direction (Y) and is laterally spaced apart therefrom in a third direction that intersects the first direction (X), and
wherein the at least one revised conductive structure (110) comprises:
a conductive via (112) on the frontside power rail (115f); and
a conductive line (111) extending in the third direction and electrically connecting the conductive via (112) to the frontside contact (108f),
wherein the frontside power rail (115f), the conductive via (112), the conductive line (111), and the frontside contact (108f) are in different layers of ECO transistor cell structure (102).

10. The integrated circuit device (100) of any one of Claims 2 to 9, further comprising:
a second transistor cell structure (101) adjacent the ECO transistor cell structure (102) in the first direction (X),
wherein the second transistor cell structure (101) overlaps the backside power rail (105b) in the second direction (Y) and is free of overlap with the frontside power rail (115f) in the second direction (Y).

11. An integrated circuit device (100), comprising:
a backside power delivery network, BSPDN (105);
a frontside power delivery network, FSPDN (115); and
an engineering change order, ECO, transistor cell structure (102) that is between the BSPDN (105) and the FSPDN (115),
wherein the ECO transistor cell structure (102) comprises a first region (I) including a first transistor structure (104-1) that is electrically connected to the FSPDN (115), and a second region (II) that is adjacent the first region (I) and electrically connects the FSPDN (115) to the BSPDN (105).

12. The integrated circuit device (100) of Claim 11, wherein the first transistor structure (104-1) in the first region (I) of the ECO transistor cell structure (102) is free of a backside contact (108b) that is electrically connected to the BSPDN (105).

13. The integrated circuit device (100) of Claim 11 or 12, wherein the BSPDN (105) does not extend under the first region (I) of the ECO transistor cell structure (102).

14. The integrated circuit device (100) of any one of Claims 11 to 13, wherein the second region (II) of the ECO transistor cell structure (102) comprises a second transistor structure (104-2) having a frontside contact (108f) that is electrically connected to the FSPDN (115), and a backside contact (108b) that is electrically connected to the BSPDN (105).

15. The integrated circuit device (100) of any one of Claims 11 to 14, wherein the first region (I) of the ECO transistor cell structure (102) comprises a frontside contact (108f) on the first transistor structure (104-1), and at least one revised conductive structure (110) that electrically connects the frontside contact (108f) to the FSPDN (115).
